Europäisches Patentamt

European Patent Office

Office européen des brevets

(11) Publication number: **0 400 163**
**A1**

## EUROPEAN PATENT APPLICATION

(21) Application number: **89109713.1**

(22) Date of filing: **30.05.89**

(51) Int. Cl.5: **G10H 1/32, G10H 1/055**

(43) Date of publication of application:
**05.12.90 Bulletin 90/49**

(84) Designated Contracting States:
**DE FR GB**

(71) Applicant: **J. FACTORY CO., LTD.**
**1-8-19, Nishi-Azabu Minato-ku**
**Tokyo(JP)**

Applicant: **Miuchi, Yasuhiko**
**4-32-6-903, Nishi-Shinjuku Shinjuku-ku**
**Tokyo(JP)**

(72) Inventor: **Miuchi, Yasuhiko**
**4-32-6-903, Nishi-Shinjuku**
**Shinjuku-ku Tokyo(JP)**

(74) Representative: **Weber, Otto Ernst, Dipl.-Phys.**
**et al**
**Weber & Heim Hofbrunnstrasse 36**
**D-8000 München 71(DE)**

(54) **Electric drum.**

(57) The main body (10) has a flat front surface provided with a plurality of keys (12). Each of the keys (12) outputs an electric signal which corresponds to the strength of impact given when the key is touched by the player. This electric signal is stored in advance in correspondence with a sound of a predetermined drum, so that the sound of the drum is produced from a synthesizer or the like with a predetermined volume. The keys (12) consist of a plurality of left-hand keys (12a) and a plurality of right-hand keys (12b), thereby enabling the desired performance of drums with both hands.

FIG. 1

## ELECTRIC DRUM

### BACKGROUND OF THE INVENTION

#### Field of the Invention

The present invention relates to an electric drum which electrically generates the sound of a drum and, more particularly, to the improvement of the operational function and the like thereof.

#### Description of the Prior Art

Various musical instruments have recently adopted electronic techniques, and with the development of an IC and an LSI, which facilitate digital processing, this tendency has become more and more pronounced. It is not surprising now that a pianist who has stuck to a grand piano for a long time should play the keyboard instrument on his feet.

Drums, however, are generally played by a primitive method still now in which a plurality of drums are beaten with sticks by the player who sits down thereto.

On the other hand, development of a synthesizer and the like enables the synthesis of the sounds of various musical instruments. For example, it is possible to store the sounds of drums by inputting them into a computer and musical performance utilizing such sounds which are controlled by the computer has been put into practice.

In musical performance on the stage, the drum sounds which are controlled by a computer are sometimes utilized, too. In this case, the players on the stage play the musical instruments such as a guitar to the accompaniment of the sounds stored in a tape or the like in advance.

Live performance of drums which are beaten by sticks is advantageous in that moving performance which will express various emotions is possible and vigorous performance which matches with the atmosphere is enabled. Such live performance, however, requires a plurality of large drums to be set at a predetermined place which generally requires as large a space as 4 m$^2$ or more, and 1 hour for setting, another 1 hour for tuning and about 1 hour for clearing, and is lucking in maneuverability. In addition, beating of drums requires too much physical strength for women, and since the drums sound large to the player, it is difficult for the sounds and singing voices of the other players to be caught on his ears.

On the other hand, in the case of using the sounds of drums which are input into a computer in advance and controlled thereby, since the sounds and rhythms are constantly inflexibly the same, vigorous performance on the stage in harmony with the atmosphere is impossible. In other words, such drum sounds are too expressionless to impress the audience.

Japanese Utility-Model Laid-Open No. 134097 1981 discloses an electric drum which electrically generates sounds by operating a plurality of keys. In the drum disclosed therein, when switches for the corresponding drums are turned on and off by touching the five keys allotted to one hand (right hand) and pedalling, the sounds of predetermined drums are generated. The volume of each drum is adjusted by operating the volume knobs with the other hand (left hand).

Such an apparatus can reduce the necessary space and produce rhythm which matches with the atmosphere. This apparatus, however, which adjusts the timing of generation of sounds and the volume of the sounds by turning on and off the switches and adjusting the volume knobs, inevitably produces very monotonous sounds which are widely different from the sounds of drums as percussion instruments, the sounds of which are varied by the manner in which sticks are beaten. In other words, the sounds of drums obtained by this apparatus are not those of drums as percussion instruments but approximate to the sounds of the keys of a known keyboard instrument such as an electronic organ which are produced in correspondence with the sounds of drums.

### SUMMARY OF THE INVENTION

Accordingly, it is an object of the present invention to eliminate the above-described problems in the prior art and to provide an electric drum which enables as impressive performance as real drums in greater variety than real drums by striking the keys while holding the electric drum with both hands.

To achieve this aim, the present invention provides an electric drum comprising:

the main body having a flat surface at least on the front surface thereof and a size which allows the player to hold the main body with both hands; and

a plurality of keys disposed on the front surface of the main body and outputting an electric signal corresponding to the strength of the impact given when a key is touched by the player;

the plurality of keys including a plurality of left-hand keys disposed in the vicinity of one end of the main body and a plurality of right-hand keys disposed in the vicinity of the other end of the main body;

whereby the electric signals output from a plurality of said keys which are touched by the player with both hands produce the sounds of plural kinds of drums with predetermined volumes in correspondence with the sounds of the plural kinds of drums which have been stored in advance.

According to an electric drum of the present invention, the player touches a plurality of left-hand keys and right-hand keys disposed on the front surface with fingers of both hands while holding the main body. The keys output electric signals corresponding to the strength of the impacts. That is, the electric signal corresponding to the strength with which the key is touched by the player is output from the key touched by the player.

The electric signal from each key corresponds to each of the sounds of a plurality of drums which are stored in advance. Therefore, when the player touches a plurality of keys with both hands, as desired, the sounds of the plural kinds of drums are produced with predetermined volumes.

Accordingly, it is possible to touch a plurality of keys with the ten fingers of both hands, thereby enabling performance in greater variety than real drums. Since it is possible to vary the volume of the sound of a drum by the strength with which the key is touched, expressive performance of a percussion instrument is enabled.

The above and other objects, features and advantages of the present invention will become clear from the following description of the preferred embodiment thereof, taken in conjunction with the accompanying drawings.

BRIEF DESCRIPTION OF THE DRAWINGS

Fig. 1 is an elevational view of an embodiment of an electric drum according to the present invention;

Fig. 2 is a sectional view of the embodiment shown in Fig. 1, taken along the line A - A;

Fig. 3 is a sectional view of the key 12 in the embodiment shown in Fig. 1; and

Fig. 4 is a schematic elevational view of the embodiment shown in Fig. 1, in the state of being used.

DESCRIPTION OF THE PREFERRED EMBODIMENT

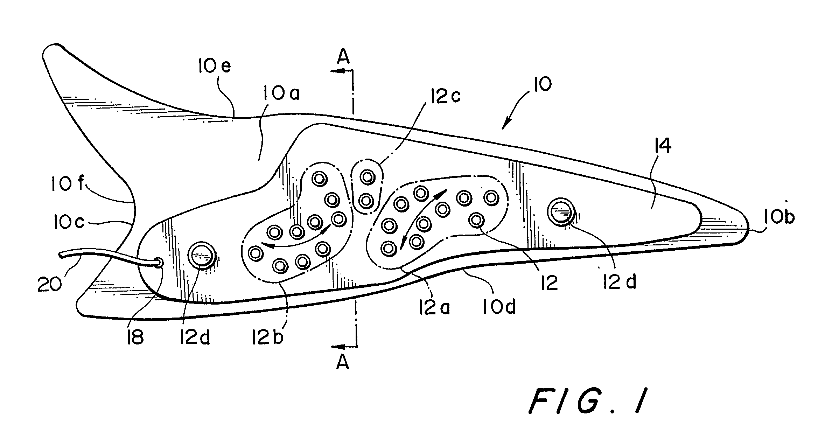

Fig. 1 is elevational view of a preferred embodiment of an electric drum according to the present invention. The front surface 10a of the main body 10 has a flat surface. The front surface 10a is provided with an adapter board 14 for attaching a plurality of keys 12 thereto. The adapter board 14 is generally attached to the front surface 10a by bolting, but other means such as adhesion may be adopted instead. Although the main body 10 is preferably made of wood and the adapter board 14 of steel, a plastic material such as an acrylic material may also be adopted.

The plurality of keys 12 are attached to the adapter board 14. In this embodiment, twenty-four keys 12 are provided. These keys 12 are divided into a plurality of groups, namely, a left-hand key group 12a, right-hand key group 12b, middle key group 12c, and special keys 12d. The left-hand key group 12a is disposed on the side near one end 10b (right end in Fig. 1) of the main body 10, while the right-hand right-hand key group 12b is disposed on the side near the other end 10c (left end in Fig. 1) of the main body 10.

· The left-hand key group 12a consists of ten keys 12, most of which are arranged in the shape of a double arc as indicated by the arrow in Fig. 1. This arrangement enables each of the fingers of the left hand to correspond to two keys 12 in ordinary performance. The right-hand key group 12b also consists of ten keys 12, most of which are arranged in the shape of a double arc as indicated by the arrow in Fig. 1. The correspondence between these keys and the fingers is not always fixed and the player can appropriately touch the keys 12, as desired. It will be understood, however, that the keys 12 arranged in the shape of an arc correspond to the finger tips of the player, which will be convenient for the player.

The middle key group 12c is disposed between the left-hand key group 12a and the right-hand key group 12b so as to be touched with either hand, as desired. The special keys 12d are disposed in the vicinity of both ends 10b and 10c, respectively of the main body 10, and slightly apart from the other keys 12. Thus, the keys 12 constitute a large group on the whole.

The main body 10 is provided with a recessed portion 10d for the left-hand in the vicinity of the left-hand key group 12a of the main body, and a recessed portion 10e for the right-hand in the vicinity of the right-hand key group 12b. The main body 10 is further provided with a recessed portion 10f for supporting the main body 10. The recessed portion 10d for the left hand and the recessed portion 10e for the right hand provided on the main body 10 enable the player to effectively touch the keys 12 with the left and right hands when the player plays the electric drum while holding the main body 10. The recessed portion 10f for supporting the main body 10 facilitates the support of the main body 10 by the leg when the player plays the electric drum while keeping his seat.

The signal from each key 12 is output from an output end 18 provided on the main body 10 to the outside of the main body 10 through a cord 20.

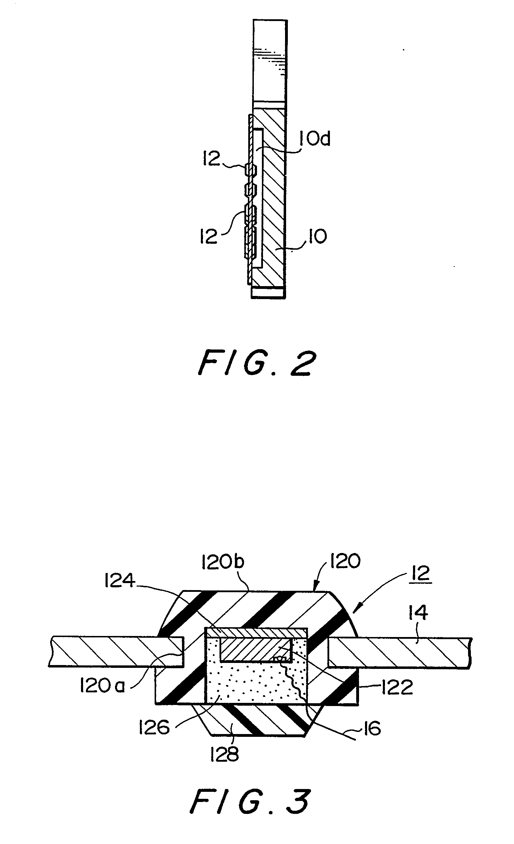

Fig. 2 is a sectional view of the embodiment shown in Fig. 1, taken along the line A - A. The recessed portion 10d is formed on the backside of the adapter board 14 of the main body 10. The recessed portion 10d accommodates the portions of the keys 12 which protrude toward the backside and the wirings therefrom.

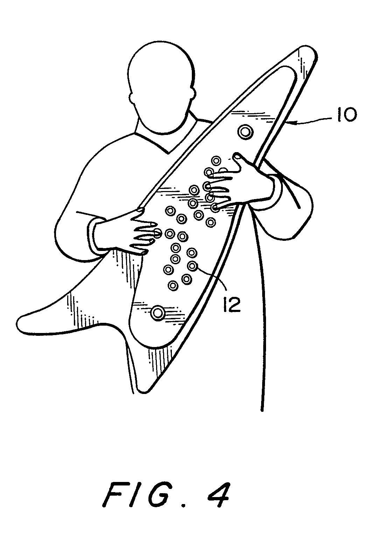

Fig. 3 shows the structure of the key 12. The key 12 is composed of an outer cylindrical material 120, a signal output device 122, an adhesive 124, an elastic filler 126 and a cover material 128. An electric signal output line 16 is connected to the signal output device 122.

An annular groove 120a is provided on the outer periphery of the outer cylindrical material 120, and the fitting portion of the adapter board 14 is inserted into the annular groove 120a. In other words, fixing holes are provided at the portions of the adaptor board 14 to which the respective keys 12 are attached, and the annular groove 120a of the key 12 is formed in correspondence to the configuration and the thickness of the fixing hole so as to be firmly fixed to the adapter board 14. The key 12 having a configuration of a frustum about 20 mm in smaller diameter and about 24 mm in larger diameter above the adapter board 14 is adopted in this embodiment in consideration of easiness of striking with the finger tip.

At the hollow portion of the outer cylindrical material 120, the signal output device 122 is connected thereto through the adhesive 124. The lower end of the outer cylindrical material 120 is sealed by the cover material 128, and the hollow portion of the outer cylindrical material 120 is filled with the elastic filler 126.

As the outer cylindrical material 120, a material having a low viscosity such as a synthetic rubber and a silicon rubber is used, and as the adhesive 124, an adhesive having a high hardness such as an acrylic adhesive and an epoxy adhesive is adopted. Since an adhesive having a high hardness is easy to destroy, it is necessary to set the hardness in consideration of the breaking strength.

As the elastic filler 126, a packaging material having an elasticity such as an acetic acid-free material and oxime-free silicon is used. The signal output device 122 instantaneously measures the acceleration applied thereto, and as the material thereof an ordinary semiconductor piezoelectric element which outputs a voltage corresponding to the strength of an impact is adopted. A piezoelectric ceramic material is the most preferred because it has a high resistance to impact and outputs a voltage which corresponds to the magnitude of impact. The signal output device 122 is generally formed into a discal shape about 0.5 to 2 mm in diameter.

The elastic filler 126 supports the signal output device 122, so that the output device 122 is effectively prevented from being broken when it is distorted.

When impact is applied to the surface 120a of the outer cylindrical material 120 of the key 12 having the above-described structure, the signal output device 122 is distorted in correspondence with the strength of impact, namely, the distortion of the surface of the key 12, and a voltage corresponding to the strength of the impact, namely, the voltage corresponding to the acceleration is output. The signal is taken out to the outside through the electric signal output line 16. As the electric signal output line 16, a very fine line such as a line having a diameter of about 0.1 to 0.3 mm is used in order not to hinder the output of a signal from the signal output device 122 due to the natural oscillation of the electric signal output line 16.

Since the signal output device 122 generates a signal when it receives impact, it involves a fear of generating a signal due to other vibration. Especially, if a signal is produced by mistake from the key 12 when another key 12 in the vicinity thereof is touched, the sound not desired is inconveniently mixed with the sound of the key 12 touched. To prevent such a wrong operation, in this embodiment, a strong steel material of about 2 mm thick is used for the adapter board 14 so as to minimize the vibration of the adapter board 14, and the space between the keys 12 is set at not less than 30 to 40 mm.

When the player plays such an electric drum, the player holds the main body 10 with both hands, such as shown in Fig. 4. In this case, hooks for a belt are preferably attached to at least two portions of the main body 10, so that the electric drum may be slung over the shoulder. In this way, the player can play the electric drum while dancing. Alternatively, the player may sit on a chair or the like with the main body 10 supported by his leg.

When the player touches a plurality of keys 12 provided on the front surface of the main body 10, the keys 12 output electric signals corresponding to the strengths with which the respective keys are touched. The electric signals are output to the cord 20 through the electric signal output line 16 and the output end 18. In other words, the cord 20 outputs the electric signals which correspond to the strengths with which the twenty-four keys 12 provided on the front surface of the main body 12 are touched.

The cord 20 is connected to an appropriate sound output apparatus (not shown), for example, an apparatus which outputs the sounds of various drums stored in advance by a similar mechanism to that of a synthesizer. Since this apparatus is so designed as to output different sounds in correspondence to the twenty-four keys 12, the sound which corresponds to the touched key 12 is output through a speaker. The signal from the signal output device 122 is an analog signal, and when it is converted to digital data by an encoder before transmission, effective signal transmission which is hardly influenced by noise is enabled.

It is possible to allot the keys 12 to the sounds of, for example, a tam-tam, a snare drum, a floor tam, high-hat cymbals, a bass drum and cymbals, respectively. In the electric drum of this embodiment, the number of the keys 12 is twenty-four. It is therefore possible to allot the keys to various sounds highly freely. For example, it is possible to allot the middle key 12c to the sound of a conga, and the special key 12d to special effects such as a human voice and a siren. It is also possible to allot each key of the left-hand key group 12a and the right-hand key group 12b arranged in the arcs, respectively, which are closer to the respective ends of the main body 10 to the sound of a single kind of drum, and each of the keys of the left-hand key group 12a and the right-hand key group 12b arranged in the arcs, respectively, which are farther from the respective ends to the sounds of a combination of plural kinds of drums.

In this way, when the player touches the twenty-four keys 12 provided on the front surface 10a of the main body 10, as desired, the sound of the desired drum is output from the speaker in correspondence with the strength with which the key is touched.

Accordingly, the player can provide vigorous performance as with real drums by touching the desired keys 12 with the desired strength which matches with the atmosphere. In addition, when the ten fingers touch the twenty-four keys 24, as desired, the sounds of the drums corresponding to the touched keys 12 are produced. It is therefore possible to produce much more kinds of sounds than conventional real drums. Since the strength of the sound corresponds to the strength at which the key is touched and the rhythm is freely varied, emotional and impressive performance which expresses the feeling of the player on the occasion is enabled.

According to the present invention, the sound of each drum is first converted to an electric signal. Various processings are therefore enabled by controlling the sound output apparatus which actually produces the sound. For example, it is possible to (A) adjust the volume of the sound to be output, (B) change the sounds which correspond to the respective keys 12 in accordance with a musical number, and (C) recognize the rhythm from the period of the signals output from the keys 12 touched for the first measure and repeat the output of the specific sounds thereafter in the rhythm.

Additionally, since the electric drum of the present invention can be played while holding the main body 10, even a visually handicapped person can advantageously play the drum, as desired, by touching the keys 12. This will be further facilitated by providing the numbers on the surfaces of the keys 12 with braille points which represent the respective keys 12.

As described above, according to the electric drum of the present invention, since it is possible to produce the sound of the desired drum in a desired rhythm and with a desired strength by touching a key on the front surface of the main body with a finger, more vigorous performance of a percussion instrument is enabled than with real drums.

While there has been described what is at present considered to be a preferred embodiment of the invention, it will be understood that various modifications may be made thereto, and it is intended that the appended claims cover all such modifications as fall within the true spirit and scope of the invention.

## Claims

1. An electric drum comprising:
the main body having a flat surface at least on the front surface thereof and a size which allows the player to hold the main body with both hands; and
a plurality of keys disposed on said front surface of said main body and outputting an electric signal corresponding to the strength of the impact given when a key is touched by the player;
said plurality of keys including a plurality of left-hand keys disposed in the vicinity of one end of said main body and a plurality of right-hand keys disposed in the vicinity of the other end of said main body;
whereby the electric signals which are output from a plurality of said keys which are touched by the player with both hands produce the sounds of plural kinds of drums with predetermined volumes in correspondence with the sounds of said plural kinds of drums which have been stored in advance.

2. An electric drum according to Claim 1, wherein said plurality of left-hand keys and said plurality of right-hand keys are respectively disposed in the shape of an arc which bulges toward the inside of said main body.

3. An electric drum according to Claim 2 or 3, wherein said plurality of left-hand keys and said plurality of right-hand keys are disposed in the shape of a double arc.

4. An electric drum according to anyone of the claims 1 to 3, wherein recessed portions are provided on said main body toward the central portions of said arcs of the respective left-hand and right-hand keys.

5. An electric drum according to anyone of the claims 1 to 4, wherein said main body is provided with a pair of hooks for receiving a belt which enables said main body to be slung over the shoulder.

6. An electric drum according to anyone of the claims 1 to 5, wherein said main body is formed into a triangle shape and a recessed portion for supporting said main body is formed on the base of said triangle shape.

7. An electric drum according to anyone of the claims 1 to 6, wherein said key is composed of a semiconductor piezoelectric element and a plastic outer cylindrical material for accommodating said semiconductor piezoelectric element at the hollow portion thereof.

8. An electric drum according to anyone of the claims 1 to 7, wherein said semiconductor piezoelectric element is fixed to said hollow portion by an electric filler with which said hollow portion is filled.

9. An electric drum according to anyone of the claims 1 to 8, wherein the space between said plurality of keys is not less than 30 mm.

10. An electric drum according to anyone of the claims 1 to 9, wherein a part of said plurality of keys consist of keys each of which is allotted to the sound of a single kind of drum, and the other part thereof consist of keys each of which is allotted to the sounds of a combination of plural kinds of drums.

FIG. 1

*FIG. 2*

*FIG. 3*

FIG. 4

# EUROPEAN SEARCH REPORT

Application Number

EP 89 10 9713

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| Y | GB-A-2 135 497 (N.B. TOMKINSON) <br> * Whole document * | 1 | G 10 H 1/32 <br> G 10 H 1/055 |
| X | | 5 | |
| A | | 2,10 | |
| Y | US-A-4 757 737 (CONTI) <br> * Column 8, line 66 - column 9, line 20; figures 1,16 * | 1 | |
| X | | 2,3 | |
| A | DE-U-8 623 250 (G. BERNAS) <br> * Page 9, lines 4-14; page 11, line 25 - page 12, line 4; figures 1,3a,3b * | 1,2,5,6 | |
| X | WO-A-8 601 927 (DYNACORD ELECTRONIC- & GERÄTEBAU) <br> * Page 4, lines 8-26; page 5, lines 7-24; page 7, line 31 - page 8, line 8; figure 1 * | 1,5 | |
| A | GB-A-2 080 613 (MEDICOR MÜVEK) <br> * Page 2, lines 42-58; figure 3 * | 7,8 | TECHNICAL FIELDS SEARCHED (Int. Cl.5) |
| A | US-A-3 712 951 (J.H. RICKARD) <br> * Column 5, line 1 - column 6, line 13; figures 5,6 * | 7,8 | G 10 H <br> H 01 L |

The present search report has been drawn up for all claims

| Place of search | Date of completion of the search | Examiner |
|---|---|---|
| THE HAGUE | 18-01-1990 | PULLUARD R.J.P.A. |

EPO FORM 1503 03.82 (P0401)